# EUROPEAN PATENT APPLICATION

(11) **EP 2 521 256 A1**
(43) Date of publication of application: **07.11.2012**
(21) Application number: 11163815.1
(22) Date of filing: 27.04.2011
(51) Int. Cl.: H03F 1/02

(54) **Energy-saving audio-amplifier control device**

(71) Applicant: ABA Electronics Technology Co. Ltd., New Taipei City (TW)
(72) Inventor: Ho, Szuyu, New Taipei City (TW); Ho, Chih-Yuan, New Taipei City (TW)
(74) Representative: Klemm, Rolf

(57) **Abstract**

An energy-saving audio-amplifier control device is electrically connected to an amplifier for sensing an audio signal input state at a sound-source input end of the amplifier and controlling the on/off of the amplifier accordingly. The control device includes a signal detection module, a control module and a power control module. The signal detection module detects the state at the sound-source input end and generates a first signal to the control module. Based on the first signal, the control module controls the power control module to control the on/off of the amplifier. With these arrangements, it is able to automatically control the amplifier to off when the audio signal input to the amplifier is ended, and accordingly, achieve the purpose of saving energy, reducing power consumption, and minimizing loss of components.

## Description

### FIELD OF THE INVENTION

The present invention relates to an energy-saving device, and more particularly to an energy-saving audio-amplifier control device that controls an audio amplifier to on/off according to the state at a sound-source input end of the amplifier.

### BACKGROUND OF THE INVENTION

Due to the constant progress in the technological fields and the quick development in production techniques, amplifier has already been widely used by people as a tool for audio apparatus to produce sound. When a signal read by a signal source device is too weak to drive a loudspeaker to output sound, an amplifier is needed to amplify the signal to a level high enough for the loudspeaker to output satisfactory sound. The presently available amplifiers can be divided according to their functions into several types, including surround amplifiers, preamplifiers, power amplifiers, and integrated amplifiers. However, these amplifiers in use must be always connected to a power source, such as a public power supply or a power supply device. Therefore, the amplifiers keep consuming power no matter whether there is any sound signal input thereto or not, particularly the amplifiers connected to indoor broadcasting systems established in, for example, schools or offices. In an indoor broadcasting system, a large number of loudspeakers are mounted at positions different from that for the amplifier and are independently connected to the public power supply or pre-provided panel boards before being connected via cables to the amplifier. Even when the broadcasting system is not in use, the amplifier is still in an active state and keeps consuming power.

It is therefore tried by the inventor to develop an energy-saving audio-amplifier control device that automatically cuts off the amplifier when the latter is not in use.

### SUMMARY OF THE INVENTION

A primary object of the present invention is to provide an energy-saving audio-amplifier control device.

Another object of the present invention is to provide an energy-saving audio-amplifier control device that automatically cuts off the amplifier when an audio signal input to the amplifier stops.

A further object of the present invention is to provide an energy-saving audio-amplifier control device that automatically switches on the amplifier when an audio signal input to the amplifier starts.

To achieve the above and other objects, the energy-saving audio-amplifier control device according to the present invention is electrically connected to a predetermined amplifier, and the amplifier receives an audio signal from a sound-source input end.

The energy-saving audio-amplifier control device according to the present invention includes a signal detection module for detecting a state at the sound-source input end and generating a first signal; a control module electrically connected to the signal detection module for receiving the first signal and generating a second signal; and a power control module electrically connected to the control module and the amplifier for controlling the on/off of the amplifier according to the second signal.

In the present invention, the control device performs the following energy-saving procedures: the signal detection module detecting the state at the sound-source input end, and generating the first signal to the control module when the state at the sound-source input end changes from having audio signal input into no audio signal input; and the control module generating the second signal to the power control module for the latter to cut off the amplifier.

On the other hand, the signal detection module generates the first signal to the control module when the state at the sound-source input end changes from no audio signal input into having audio signal input, and the control module generates the second signal to the power control module for the latter to switch on the amplifier.

Therefore, when the amplifier works, power can be continuously supplied to the amplifier; and when the audio signal input stops, the control device automatically cuts off the amplifier to avoid unnecessary power consumption. On the other hand, when the sound-source input end has audio signal input again, the control device would immediately switch on the amplifier for the same to work.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 is a block diagram of an energy-saving audio-amplifier control device according to a first embodiment of the present invention;
Fig. 2 is an operation flowchart showing the energy-saving procedures of the energy-saving audio-amplifier control device according to the first embodiment of the present invention;
Fig. 3 is a block diagram of an energy-saving audio-amplifier control device according to a second embodiment of the present invention;
Fig. 4 is a block diagram of an energy-saving audio-amplifier control device according to a third embodiment of the present invention; and
Fig. 5 is a block diagram of an energy-saving audio-amplifier control device according to a fourth embodiment of the present invention.

### DETAILED DESCRIPTION OF THE PREFERRED EMBODIMENTS

The present invention will now be described with some preferred embodiments thereof and with reference to the accompanying drawings. For the purpose of easy to understand, elements that are the same in the preferred embodiments are denoted by the same reference numerals.

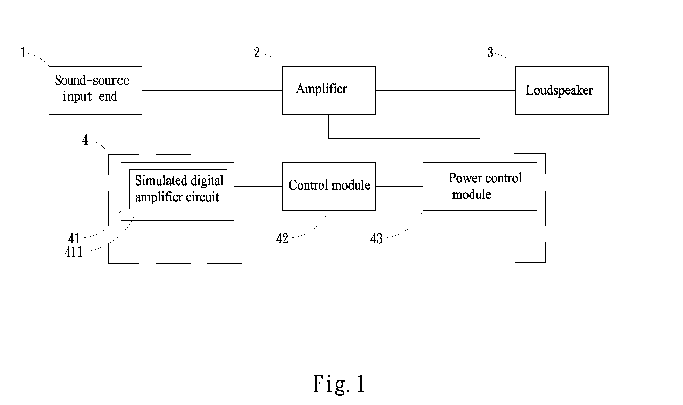

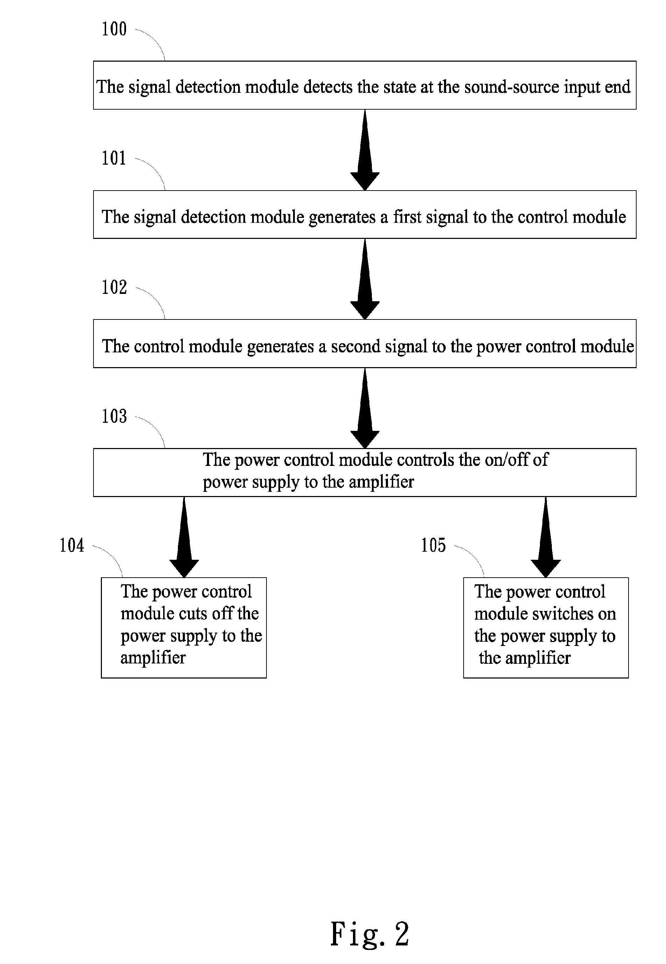

Please refer to Figs. 1 and 2 that are block diagram and operation flowchart, respectively, for an energy-saving audio-amplifier control device according to a first embodiment of the present invention. As shown, the energy-saving audio-amplifier control device 4 in the first embodiment is externally connected to an amplifier 2.

The amplifier 2 is electrically connected to a sound-source input end 1 and a loudspeaker 3. Two types of sound-source input end 1 are available. The first type of sound-source input end 1 includes a voice input device, such as a cabled or a wireless microphone, for receiving and converting a speech signal into an electronic signal. This type of sound-source input end 1 can be directly electrically connected to the amplifier 2 via, for example, an audio connector, a USB connector, or a wireless signal (such as Bluetooth, WiFi, etc.). The second type of sound-source input end 2 includes an audio input end of the amplifier 2. Since there are various types of amplifiers 2 for different purposes, such as component stereo, large-scale broadcasting system and car stereo system, the amplifiers 2 will not be independently connected to a microphone or other types of audio input devices. Therefore, in a broad sense, the second type of sound-source input end 1 generally refers to a connection point for guiding an external audio signal into the amplifier 2, such as an audio connection, an audio connector, a wireless receiver for receiving wirelessly transmitted audio signal, or an audio input terminal for transmitting an audio signal from a network, such as Ethernet, or via a coaxial cable or IEEE 1394 to the amplifier 2. Further, the loudspeaker 3 generally refers to a sound output device, such as a speaker, an earphone, or a cabinet. The sound-source input end 1 receives a speech signal and converts the same into an audio signal, which is then transmitted to the amplifier 2 and amplified for outputting.

The control device 4 is electrically connected to the amplifier 2, and includes a signal detection module 41, a control module 42, and a power control module 43.

The signal detection module 41 is electrically connected to between the amplifier 2 and the sound-source input end 1 for detecting a state at the sound-source input end 1 and generating a first signal. The signal detection module 41 is internally provided a simulated digital amplifier circuit 411. When the signal detection module 41 receives an audio signal, the simulated digital amplifier circuit 411 performs an amplifying process according to the amplitude of the received audio signal and generates the first signal.

In addition to the above-described manner, the signal detection module 41 can also detect audio signals in other manners. For example, the signal detection module 41 can determine whether there is any audio signal input according to a signal state at the sound-source input end 1. Since an audio signal is mainly an analog signal and has fixed amplitude and frequency, the signal detection module 41 can determine that there is not audio signal input when the received audio signal has excessively high or low frequency and relatively low voltage amplitude. Alternatively, the signal detection module 41 can, via a filter and the like, directly isolate noises to determine whether there is any audio signal input. It is understood the above description of the signal detection manners of the signal detection module 41 is only illustrative and not intended to limit the present invention, and any skills or techniques or circuit structures that can be used to detect any audio signal input also fall within the protection scope of the present invention.

The control module 42 is electrically connected to the signal detection module 41 for receiving the first signal generated by the latter, and determining whether to cut off the amplifier 2 according to the first signal.

The power control module 43 is electrically connected to the control module 42 and the amplifier 2. After receiving the first signal, the control module 42 generates a second signal to the power control module 43 for the latter to control the on/off state of the amplifier 2. It is noted the power control module 43 can be connected to the amplifier 2 in at least two different manners. In the first manner, the power control module 43 is connected to an internal power supply or a power input terminal of the amplifier 2. In the second manner, the power control module 43 is connected to a power output terminal of a power supply device that is connected to the amplifier 2. The power supply device can be a central control circuit, a panel board or an uninterruptible power system. It is understood the above description of the implementing manners of the power control module 43 is only illustrative and not intended to limit the actual structure or circuit of the power control module 43 in any way, and any skills or techniques or circuit structures that can be used to control the power input to the amplifier also fall within the protection scope of the present invention.

It is noted the control device 4 may be implemented in different forms, such as an integrated IC (integrated circuit) integrating the signal detection module 41, the control module 42, and the power control module 43 into one single IC circuit; or an integrated circuit with the signal detection module 41, the control module 42 and the power control module 43 respectively being an individually packaged IC and connected to one another via a printed circuit board (PCB); or an electronic circuit with the three modules 41, 42, 43 respectively being an electronic component and connected to one another via a PCB; or any combination of the above forms. Further, the control device 4 can be electrically connected to the amplifier 2 by mounting it in the amplifier 2, integrating it into an internal circuit of the amplifier 2, or externally electrically connecting it to the amplifier 2. Similarly, the signal detection module 41 and the power control module 43 can be connected to the amplifier 2 in the above-mentioned manners.

Fig. 2 shows the operation procedures 100∼105 of the energy-saving audio-amplifier control device according to the first embodiment of the present invention

In the operation procedure 100, the signal detection module 41 detects a state at the sound-source input end 1.

More specifically, in the operation procedure 100, the signal detection module 41 is electrically connected to between the amplifier 2 and the sound-source input end 1, and starts detecting whether there is any audio signal input at the sound-source input end 1.

In the operation procedure 101, the signal detection module 41 generates a first signal to the control module 42.

More specifically, in the operation procedure 101, when the state at the sound-source input end 1 is changed from having audio signal input into no audio signal input, or changed from no audio signal input into having audio signal input, the signal detection module 41 generates a first signal to the control module 42.

In the operation procedure 102, the control module 42 generates a second signal to the power control module 43.

More specifically, in the operation procedure 102, the control module 42 generates a second signal according to the state represented by the first signal, and the second signal is transmitted to the power control module 43 to determine the latter's movement. In the case the first signal indicates the state at the sound-source input end 1 is changed from having audio signal input into no audio signal input, the second signal controls the power control module 43 to cut off the power supply to the amplifier 2. On the other hand, when the first signal indicates the state at the sound-source input end 1 is changed from no audio signal input into having audio signal input, the second signal controls the power control module 43 to switch on the power supply to the amplifier 2.

In the operation procedure 103, the power control module 43 controls the power on/off of the amplifier 2.

More specifically, in the operation procedure 103, based on the second signal from the control module 42, the power control module 43 determines the power supply condition of the amplifier 2. In the case the state at the sound-source input end 1 is changed from having audio signal input into no audio signal input, the operation procedure 104 is performed. On the other hand, when the state at the sound-source input end 1 is changed from no audio signal input into having audio signal input, the operation procedure 105 is performed.

In the operation procedure 104, the power control module 43 cuts off the power supply to the amplifier 2.

And, in the operation procedure 105, the power control module 43 switches on the power supply to the amplifier 2.

With the energy-saving audio-amplifier control device of the present invention, when the amplifier 2 works, the signal detection module 41 of the control device 4 keeps detecting the amplifier 2 or the state at the sound-source input end 1. When the sound-source input end 1 has not any audio signal input, the control device 4 will cut off the amplifier 2 to avoid unnecessary power consumption. On the other hand, when the sound-source input end 1 has audio signal input, the control device 4 will switch on the amplifier 2 for the same to work.

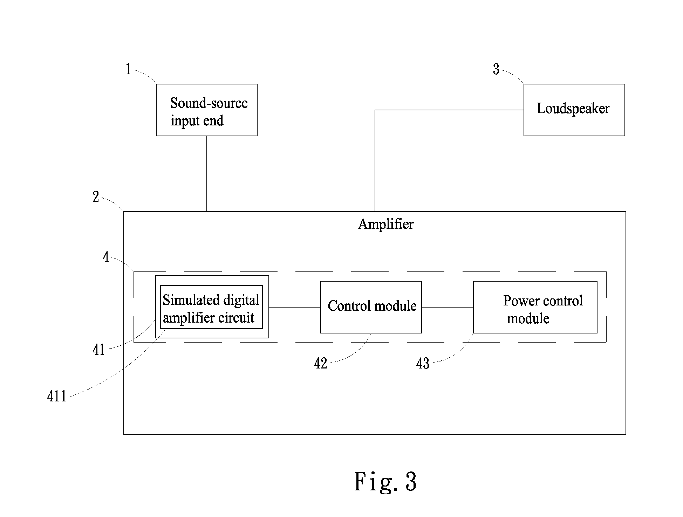

Please refer to Fig. 3 that is a block diagram of an energy-saving audio-amplifier control device 4 according to a second embodiment of the present invention. In the first embodiment, the control device 4 is located outside the amplifier 2. However, in the second embodiment, the control device 4 is provided inside the amplifier 2 with the signal detection module 41 connected to a connector (not shown) of the amplifier 2, such as a sound source signal connector, a USB (universal serial bus) connector or a wireless receiver, and the power control module 43 connected to a power supply circuit or the power input terminal of the amplifier 2.

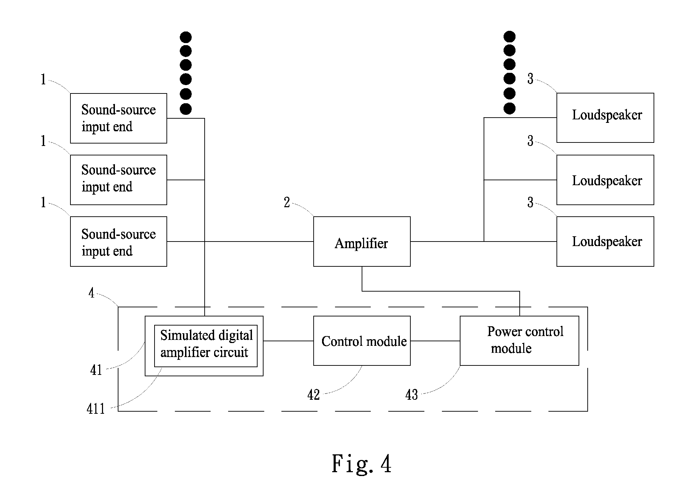

Please refer to Fig. 4 that is a block diagram of an energy-saving audio-amplifier control device 4 according to a third embodiment of the present invention. The third embodiment is generally structurally similar to the first embodiment, except that, in the third embodiment, the amplifier 2 is simultaneously connected to multiple sets of sound-source input ends 1 or multiple sets of loudspeakers 3. When the amplifier 2 in the third embodiment is in use, the control device 4 detects the audio signal input state at each of the multiple sound-source input ends 1 and determines the power on/off state of the amplifier 2 accordingly.

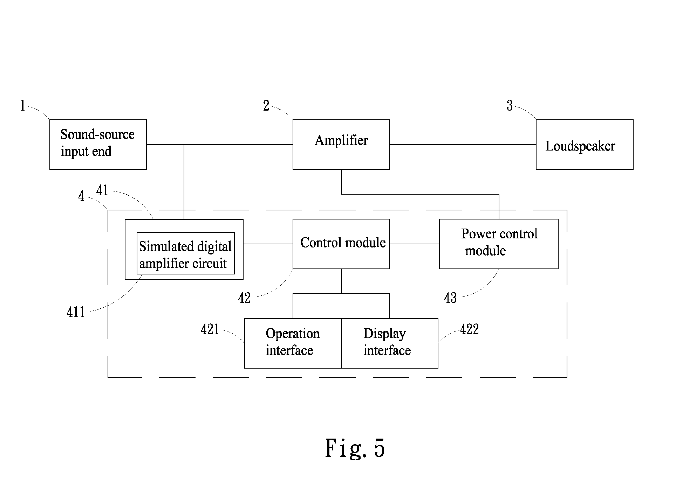

Fig. 5 is a block diagram of an energy-saving audio-amplifier control device 4 according to a fourth embodiment of the present invention. The fourth embodiment is generally structurally similar to the first embodiment, except that, in the fourth embodiment, the control module 42 of the control device 4 is further provided with an operation interface 421 and a display interface 422.

The operation interface 421 is electrically connected to the control module 42 for a user to set the movement for the control device 4. For example, the signal detection module 41 can detect and determine whether there is any audio signal input at the sound-source input end 1 or at the amplifier 2 according to the intensity of the detected audio signal and/or the intervals between changes of the audio signal. That is, a sudden interruption lasted for a few seconds while the audio signal is being continuously input might occur when the speaker temporarily stops speaking or due to signal delay. To avoid repeatedly switching on or off the amplifier 2 many times within a very short time period, the user may make settings via the operation interface 421, so that the control module 42 does not cut off the amplifier 2 when the audio signal is interrupted for only a short time. On the other hand, it is also possible a sudden audio signal input occurs at the sound-source input end 1 and lasts only for a few seconds while the amplifier 2 is cut off. The user may make settings via the operation interface 421, so that the control module 42 does not switch on the amplifier 2 when the audio signal input only lasts for a very short time period. It is noted the user can use the operation interface 421 to set the duration or intervals of the above-mentioned short time periods. Alternatively, the settings of the durations or intervals, during or at which the audio signal input changes, can be preset in the control module 42 of the energy-saving audio-amplifier control device 4 shown in Fig. 1. With the fourth embodiment shown in Fig. 5, the user may operate at the operation interface 421 to change the preset settings. According to the present invention, the operation interface 421 may be a mechanical switch, such as a DIP (dual-in-line) switch, a toggle switch, a push-button switch, a rocker switch, a contact switch, a band switch, a micro switch or a proximity switch; or an electronic switch, such as a membrane switch or a touch switch; or a touch panel, such as a resistive touch panel, a capacitive touch panel, an optical touch panel, or a SAW (surface acoustic wave) touch panel.

The display interface 422 is electrically connected to the control module 42 for displaying the current state of the control device 4 or the amplifier 2. For instance, the display interface 422 may display the current on/off state of the amplifier 2. When the signal detection module 41 keeps detecting whether there is any audio signal input or any change in the received audio signal, the display interface 422 also displays the current state detected by the signal detection module 41, such as the number of times of noise input, the number of times of signal interruption, etc., so that the user can have an idea about the working state of the amplifier 2 and the control device 4. Moreover, the display interface 422 may be a seven-segment display, an LED (light-emitting-diode) array display, or an LCD (liquid crystal display) panel.

It is understood that, in practical implementation of the present invention, the operation interface 421 and the display interface 422 are not necessarily provided at the same time. That is, the present invention can be designed according to actual need in application to include both or one of the operation interface 421 and the display interface 422.

The present invention has been described with some preferred embodiments thereof and it is understood that many changes and modifications in the described embodiments can be carried out without departing from the scope and the spirit of the invention that is intended to be limited only by the appended claims.

## Claims

1. An energy-saving audio-amplifier control device for electrically connecting to a predetermined amplifier that receiving an audio signal from a sound-source input end and amplifying the received audio signal for outputting; the energy-saving audio-amplifier control device comprising:
a signal detection module being electrically connected to between the amplifier and the sound-source input end for detecting a state at the sound-source input end and generating a first signal accordingly;
a control module being electrically connected to the signal detection module and generating a second signal according to the first signal; and
a power control module being electrically connected to the control module and the amplifier, and controlling the amplifier to on/off according to the second signal.

2. The energy-saving audio-amplifier control device as claimed in claim 1, wherein the sound-source input end is selected from the group consisting of a cabled microphone and a wireless microphone.

3. The energy-saving audio-amplifier control device as claimed in claim 1, wherein the power control module is provided inside the amplifier.

4. The energy-saving audio-amplifier control device as claimed in claim 3, wherein the power control module is a power supply module pre-provided inside the amplifier.

5. The energy-saving audio-amplifier control device as claimed in claim 1, wherein the power control module is selected from the group consisting of a mechanical switch and an electronic switch.

6. The energy-saving audio-amplifier control device as claimed in claim 1, wherein the control module includes an operation interface for setting movement parameters for the control device.

7. The energy-saving audio-amplifier control device as claimed in claim 6, wherein the operation interface is selected from the group consisting of a mechanical switch, an electronic switch, and a touch panel.

8. The energy-saving audio-amplifier control device as claimed in claim 1, wherein the control module includes a display interface for displaying operating states of the control device.

9. The energy-saving audio-amplifier control device as claimed in claim 8, wherein the display interface is selected from the group consisting of a 7-segment display, an LED array display, and an LCD panel.

10. The energy-saving audio-amplifier control device as claimed in claim 1, wherein the signal detection module is internally provided a simulated digital amplifier circuit for receiving the audio signal and performing an amplifying process according to amplitude of the audio signal to thereby generate the first signal to the control module.
